# EUROPEAN PATENT APPLICATION

(11) **EP 4 665 103 A1**
(43) Date of publication of application: **17.12.2025**
(21) Application number: 25181395.2
(22) Date of filing: 06.06.2025
(51) Int. Cl.: H05K 7/20, H01G 2/04, H01G 2/08, H01G 4/32, H02M 7/00

(54) **SYSTEMS FOR HOUSING POCKETS FOR INVERTER FOR ELECTRIC VEHICLE**

(30) Priority: 12.06.2024 US 202463658919 P; 30.01.2025 US 202519041427
(71) Applicant: BorgWarner US Technologies LLC, Wilmington, DE 19801 (US)
(72) Inventor: LAWRENCE, Robert Anthony, Frankfort, IN (US); VAS, Timothy A., Kokomo, IN (US)
(74) Representative: Office Freylinger

(57) **Abstract**

A system includes a heat sink for a capacitor assembly for an inverter, the heat sink including: a first pocket extending from a chassis of the inverter, wherein the first pocket includes a first surface configured to transfer heat from a first surface of a first capacitor and a second surface configured to transfer heat from a second surface of the first capacitor; and a second pocket extending from the chassis of the inverter, wherein the second pocket includes a first surface configured to transfer heat from a first surface of a second capacitor and a second surface configured to transfer heat from a second surface of the second capacitor.

## Description

### CROSS-REFERENCE TO RELATED APPLICATION(S)

This application claims the benefit of priority to U.S. Provisional Patent Application No. 63/658,919, filed June 12, 2024, the entirety of which is incorporated by reference herein.

### TECHNICAL FIELD

Various embodiments of the present disclosure relate generally to a heatsink for a capacitor system, and, more particularly, to a system for cast housing pockets for thermal management.

### INTRODUCTION

Thermal management is considered a key technical aspect in an electric vehicle system. A cooling module of an inverter system controls the performance and efficiency of an overall driving system of an electric vehicle. However, some cooling modules may have limited capability for thermal management.

The present disclosure is directed to overcoming one or more of these above-referenced challenges.

### SUMMARY OF THE DISCLOSURE

In some aspects, the techniques described herein relate to a system including a heat sink for a capacitor assembly for an inverter, the heat sink including: a first pocket extending from a chassis of the inverter, wherein the first pocket includes a first surface configured to transfer heat from a first surface of a first capacitor and a second surface configured to transfer heat from a second surface of the first capacitor; and a second pocket extending from the chassis of the inverter, wherein the second pocket includes a first surface configured to transfer heat from a first surface of a second capacitor and a second surface configured to transfer heat from a second surface of the second capacitor.

In some aspects, the techniques described herein relate to a system, wherein the second surface of the first pocket is on an opposite side of a wall from the first surface of the second pocket.

In some aspects, the techniques described herein relate to a system, wherein the first surface of the first pocket is opposite to the second surface of the first pocket.

In some aspects, the techniques described herein relate to a system, wherein the first pocket further includes: a third surface connecting the first surface of the first pocket to the second surface of the first pocket, the third surface being configured to transfer heat from a third surface of the first capacitor.

In some aspects, the techniques described herein relate to a system, wherein the first pocket further includes: a fourth surface connecting the first surface of the first pocket to the second surface of the first pocket, the fourth surface opposite to the third surface of the first pocket and being configured to transfer heat from a fourth surface of the first capacitor.

In some aspects, the techniques described herein relate to a system, wherein the heat sink further includes: thermally conductive gap filler between the first surface and first capacitor.

In some aspects, the techniques described herein relate to a system, wherein the heat sink is cast aluminum.

In some aspects, the techniques described herein relate to a system, wherein the heat sink is configured to receive coolant through an inlet and an outlet of the chassis.

In some aspects, the techniques described herein relate to a system, wherein the heat sink further includes: a floor extending across the first pocket and the second pocket, and integrated with the chassis of the inverter.

In some aspects, the techniques described herein relate to a system, wherein the first pocket further includes a recess to receive a protrusion of the first capacitor to position the first capacitor in the first pocket.

In some aspects, the techniques described herein relate to a system further including: the inverter including the heat sink, the inverter configured to convert DC power from a battery to AC power to drive a motor, the battery configured to supply the DC power to the inverter; and the motor configured to receive the AC power from the inverter to drive the motor, wherein the inverter, the battery, and the motor are provided as a vehicle.

In some aspects, the techniques described herein relate to a system including an inverter to convert direct current (DC) power from a battery to alternating current (AC) power to drive a motor, wherein the inverter includes: a chassis including a floor and a heat sink for a capacitor assembly, the heat sink including: a first pocket extending from the floor of the chassis, wherein the first pocket includes a first surface configured to transfer heat from a first surface of a first capacitor and a second surface configured to transfer heat from a second surface of the first capacitor; and a second pocket extending from the floor of the chassis, wherein the second pocket includes a first surface configured to transfer heat from a first surface of a second capacitor and a second surface configured to transfer heat from a second surface of the second capacitor.

In some aspects, the techniques described herein relate to a system, wherein the heat sink is configured to transfer heat from the first capacitor and the second capacitor to the floor of the chassis.

In some aspects, the techniques described herein relate to a system, wherein the chassis further includes an inlet for coolant and an outlet for the coolant.

In some aspects, the techniques described herein relate to a system, wherein the first surface of the first capacitor and the second surface of the first capacitor are end caps of the first capacitor.

In some aspects, the techniques described herein relate to a system, wherein one or more of the first pocket or the floor includes a recess to receive a protrusion of the first capacitor to position the first capacitor in the first pocket.

In some aspects, the techniques described herein relate to a system including a heat sink, the heat sink including: a first pocket of a chassis, wherein the first pocket includes a first surface configured to receive heat from a first connection plate of a first capacitive element and a second surface configured to receive heat from a second connection plate of the first capacitive element; and a second pocket of the chassis, wherein the second pocket includes a first surface configured to receive heat from a first connection plate of a second capacitive element and a second surface configured to receive heat from a second connection plate of the second capacitive element.

In some aspects, the techniques described herein relate to a system, wherein the heat sink and the chassis are cast aluminum.

In some aspects, the techniques described herein relate to a system, wherein the chassis further includes an inlet for coolant and an outlet for the coolant.

In some aspects, the techniques described herein relate to a system, wherein the heat sink further includes a sidewall providing a third surface for the first pocket and the second pocket.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including an inverter, according to one or more embodiments.
FIG. 2 depicts an electrical power schematic of a three phase inverter module, according to one or more embodiments.
FIG. 3 depicts an exemplary inverter assembly including a chassis and capacitor assembly, according to one or more embodiments.
FIG. 4 depicts an exemplary capacitor element, according to one or more embodiments.
FIG. 5 depicts a cross section of an exemplary inverter package, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. For example, in the context of the disclosure, the switching devices may be described as switches or devices, but may refer to any device for controlling the flow of power in an electrical circuit. For example, switches may be metal-oxide-semiconductor field-effect transistors (MOSFETs), bipolar junction transistors (BJTs), insulated-gate bipolar transistors (IGBTs), or relays, for example, or any combination thereof, but are not limited thereto.

Various embodiments of the present disclosure relate generally to a heat sink for a capacitor system, and, more particularly, to a system for cast housing pockets for thermal management.

Inverters, such as those used to drive a motor in an electric vehicle, for example, are responsible for converting High Voltage Direct Current ("HVDC") into Alternating Current ("AC") to drive a motor. Inverters may include a power module and corresponding cooling modules assemblies configured to cool the power modules. Power module may include one or more silicon carbide ("SiC")-based power switches that deliver relatively high power densities and efficiencies needed to extent battery range and performance. The power module may contain circuitry and components that are configured to convert DC current from the electric vehicle battery to AC current, which can be utilized within the electric motor that drives the propulsion system. The heat sink (e.g., the chassis of the inverter) may receive heat generated during operation of the capacitor, which may cool the capacitor and lower an equivalent series inductance ("ESL") between a battery and motor of the electric vehicle.

Inverter systems may have high ambient temperature during operation. The performance, assembly process and time, and reliability of the power modules of an inverter system may all be dependent on a built-in coolant structure. The heat sink of the inverter systems may improve performance and reliability.

Vehicles with electrified propulsion such as electric vehicles ("EVs"), hybrid electric vehicles ("HEVs"), plug-in hybrid electric vehicles ("PHEVs"), etc., may include inverters that require a capacitor (e.g., DC bulk capacitor) to provide filtering (or adequate filtering) of electrical noise. Power of an inverter used to control and drive electric motors may produce significant heat in a DC bulk capacitor, which must be managed to prevent (or reduce) thermal overload and permanent damage (or any damage) to the part. Internal construction of capacitors includes several wound capacitive elements or bobbins, which may be electrically connected in parallel or in series via electrical conductors (e.g., busbars), which are typically manufactured from stamped copper. Electrical components are then encased with a plastic housing and potting material such as epoxy to prevent environmental contamination and provide electrical isolation.

Environmental and electrical isolation may retain unwanted heat in the capacitor elements or bobbins, which may have thermal limitations. Cooling may be external only and poor at best because of the insulating materials. One or more embodiments may extract heat from the interior heat source of the capacitor.

In some systems, internal cooling of bobbins and/or capacitive elements may not be practical, and unwanted waste heat may be extracted from a perimeter of a capacitor assembly through various insulating materials such as plastic enclosures and epoxy materials. Accordingly, in some systems, heat extraction and/or efficiency may be poor.

In one or more embodiments described herein, a problem of thermal overload of capacitive elements without cooling of electrode plate(s) may be addressed by using extended wall sections to create pockets in aluminum chassis walls to provide a path for heat transfer from end caps of capacitive elements to the aluminum chassis.

One or more embodiments may include an integration and placement of bulk capacitor components within a main inverter enclosure (e.g., a chassis). The main inverter enclosure may be generally made from highly conductive aluminum and may be constructed in such a way to surround each capacitor bobbin and/or element for enabling internal heat sinking.

One or more embodiments may include extended wall sections, which may provide pockets in aluminum chassis walls to increase available surface areas to end caps of capacitive elements. In one or more embodiments, a thermal conductivity of the capacitive elements may be approximately six times (e.g., 6x) better in a direction between the end caps of the capacitive elements than across the body of the capacitive elements.

In one or more embodiments, additional surface area of casting walls next to optimum surfaces of the capacitive elements for cooling may compensate for the relatively poor thermal conductivity of high voltage insulation and epoxy. In one or more embodiments, an interface may be provided with a more efficient (or improved) path for heat transfer from the end caps of the capacitive elements than cooling from the exterior through multiple insulating materials.

In one or more embodiments, by increasing the thermal efficiency of the bulk capacitor, less capacitance may be used in cases where thermal limitations are driving the amount of capacitance compared to electrical filtering. In one or more embodiments, the extended wall pockets in the aluminum chassis casting may provide additional surface area and a more efficient path for heat transfer through the High Voltage+ (HV+) / High Voltage- (HV-) end caps of the capacitive elements. In one or more embodiments, using aluminum material as a heatsink may be beneficial for being less expensive than extra copper bus bars and the extended wall pockets may increase a stiffness of the aluminum chassis casting.

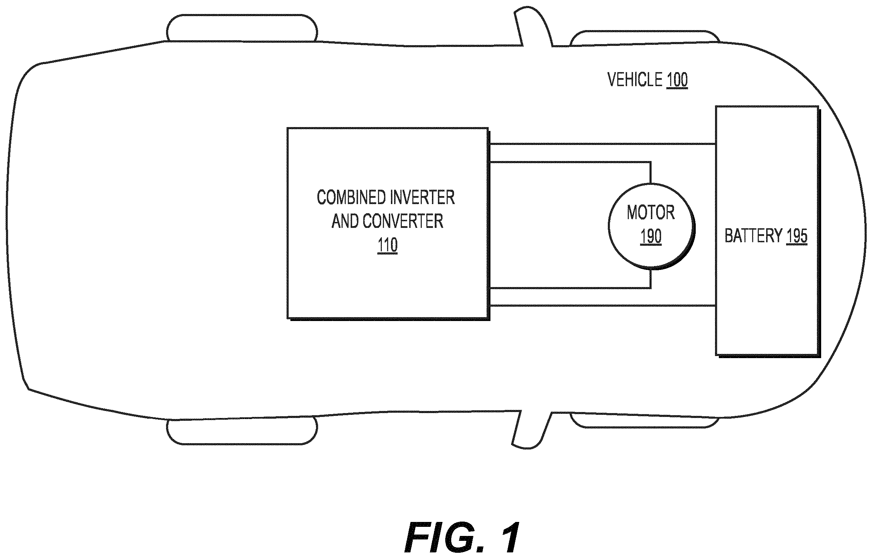

FIG. 1 depicts an exemplary system infrastructure for a vehicle including a combined inverter and converter, according to one or more embodiments. Alternatively, the inverter may be an inverter without a converter. In the context of this disclosure, the inverter without a converter, or the combined inverter and converter, may be referred to as an inverter. This disclosure provides an inverter as an example embodiment, but the disclosure is not limited to an inverter, and the description herein may be applied to any power converter or other electrical system that includes a capacitor. As shown in FIG. 1, electric vehicle 100 may include an inverter 110, a motor 190, and a battery 195. The inverter 110 may include components to receive electrical power from an external source and output electrical power to charge the battery 195 of electric vehicle 100. The inverter 110 may convert DC power from the battery 195 in electric vehicle 100 to AC power, to drive (e.g. rotate) the motor 190 of the electric vehicle 100, for example, but the embodiments are not limited thereto. The inverter 110 may be bidirectional, and may convert DC power to AC power, or convert AC power to DC power, such as during regenerative braking, for example. The inverter 110 may be a three-phase inverter, a single-phase inverter, or a multi-phase inverter.

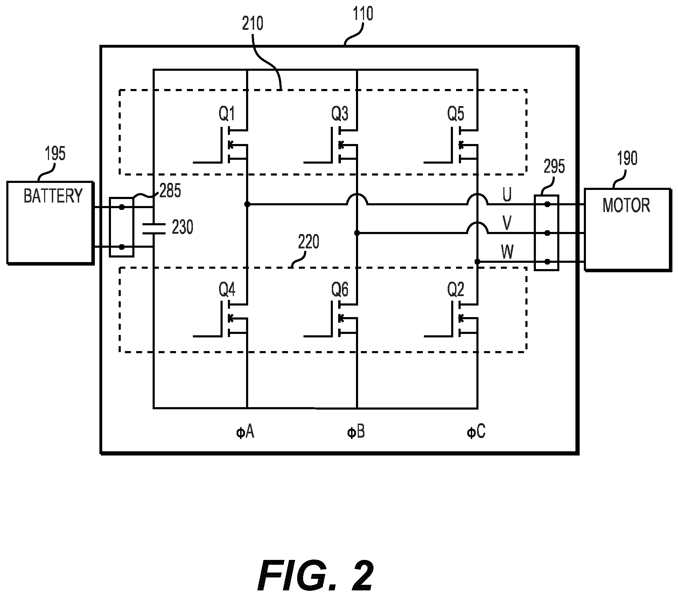

FIG. 2 depicts an electrical power schematic of a three phase inverter module, according to one or more embodiments. As shown in FIGS. 1 and 2, the inverter 110 may be connected to the battery 195 and the motor 190. Battery 195 may be any power supply, and motor 190 may be any load. The inverter 110 may include first three-phase switch group 210, and second three-phase switch group 220. A first phase U may correlate with ΦA including switches Q1 and Q4, a second phase V may correlate with ΦB including switches Q3 and Q6, and a third phase W may correlate with ΦC including switches Q5 and Q2, as illustrated in FIG. 2. The first three-phase switch group 210 may include first phase switch Q1, second phase switch Q3, and third phase switch Q5. The second three-phase switch group 220 may include first phase switch Q4, second phase switch Q6, and third phase switch Q2. The switches Q1-Q6 may be metal-oxide-semiconductor field-effect transistors (MOSFET), for example, but are not limited thereto.

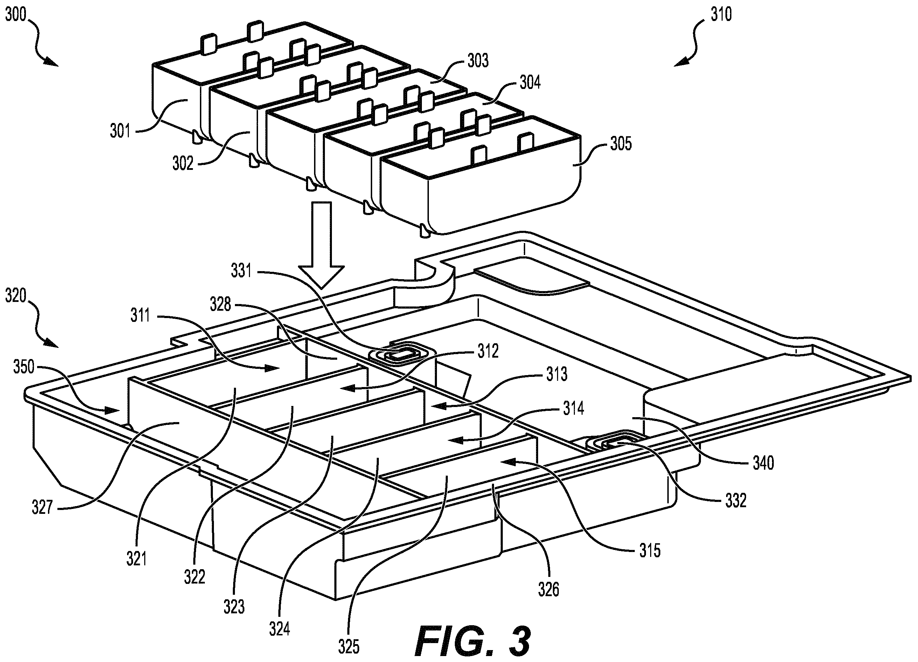

The first three-phase switch group 210 and second three-phase switch group 220 may be driven by a PWM signal generated by inverter assembly 300 (shown in FIG. 3) to convert DC power delivered via input terminal set 285 at capacitor 230 to three phase AC power at outputs U, V, and W via output terminal set 295 to the motor 190. Additionally, although FIGS. 1 and 2 illustrate a three-phase inverter, the disclosure is not limited thereto, and may include single phase or multi-phase inverters.

FIG. 3 depicts an exemplary inverter assembly 300 including a capacitor assembly 310 and a chassis 320, according to one or more embodiments. The inverter assembly 300 may be components of inverter 110 of FIG. 1 and FIG. 2 described above. The chassis 320 may include a heat sink 350 configured to receive the capacitor assembly 310 as indicated by the arrow in FIG. 3.

The capacitor assembly 310 may include a capacitor (e.g., one or more capacitors, e.g., five capacitors, e.g., capacitor 230) or other capacitive elements. The capacitor assembly 310 may include a first capacitor 301, a second capacitor 302, a third capacitor 303, a fourth capacitor 304, and a fifth capacitor 305. However, the disclosure is not limited to five capacitors, and may include fewer or more capacitors. The capacitors of the capacitor assembly 310 (e.g., first capacitor 301, second capacitor 302, third capacitor 303, fourth capacitor 304, and fifth capacitor 305) may be connected via electrical conductors, such as a copper material, for example.

The chassis 320 may include a heat sink 350 that extends from a floor 340 of the chassis 320. The heat sink 350 may include an aluminum alloy, copper, or other suitable material that is thermally conductive. The chassis 320 and heat sink 350 may be cast aluminum, for example. The heat sink 350 may be configured to receive the capacitor assembly 310 and to remove heat from the capacitor assembly 310. This may provide effective cooling of the capacitor assembly 310. As will be described in greater detail below, the respective capacitors of the capacitor assembly 310 may be surrounded by wall(s) of the heat sink 350, which may enable internal heat sinking of the capacitor assembly 310.

The heat sink 350 may include a wall (e.g., one or more walls, e.g., eight walls) that extends from floor 340 of the chassis 320. The wall (e.g., one or more walls, e.g., four walls) and their respective surfaces may define a pocket (e.g. one or more pockets, e.g., five pockets). The pocket may be configured to receive one or more capacitors of the capacitor assembly 310. The heat sink 350 may include a respective pocket for each capacitor of the capacitor assembly 310. The capacitors may transfer heat to the respective walls of the heat sink 350.

The heat sink 350 may include a first wall 321, a second wall 322, a third wall 323, a fourth wall 324, a fifth wall 325, and a sixth wall 326. These walls may each extend from the floor 340 of the chassis 320. Each of the first wall 321, the second wall 322, the third wall 323, the fourth wall 324, the fifth wall 325, and the sixth wall 326 may include a surface configured to transfer heat from a respective capacitor. The walls (e.g., first wall 321, second wall 322, third wall 323, fourth wall 324, fifth wall 325, and sixth wall 326) of heat sink 350 may be substantially parallel to one another in a stacked formation along the floor 340. The first wall 321 and sixth wall 326 may extend to a height that is higher than the second wall 322, the third wall 323, the fourth wall 324, and the fifth wall 325. The walls of heat sink 350 may extend a length that is substantially the same as a length of the respective capacitors of capacitor assembly 310.

The heat sink 350 may include a first sidewall 327 and a second sidewall 328 that extend from the floor 340 of the chassis 320. The first sidewall 327 and second sidewall 328 may extend to a height that is substantially the same as a height of the first wall 321 and sixth wall 326. The first sidewall 327 and second sidewall 328 may extend in a direction that is substantially perpendicular to a longitudinal direction of the first wall 321, the second wall 322, the third wall 323, the fourth wall 324, the fifth wall 325, and the sixth wall 326. The first sidewall 327 and second sidewall 328 may extend across a length of the floor 340 of the chassis 320. The first sidewall 327 may be configured to contact first ends of the first wall 321, the second wall 322, the third wall 323, the fourth wall 324, the fifth wall 325, and the sixth wall 326. The second sidewall 328 may be configured to contact second ends of the first wall 321, the second wall 322, the third wall 323, the fourth wall 324, the fifth wall 325, and the sixth wall 326.

The heat sink 350 may include a pocket defined by respective walls and surfaces of the heat sink 350. For example, the heat sink 350 may include a first pocket 311, a second pocket 312, a third pocket 313, a fourth pocket 314, and a fifth pocket 315. The first pocket 311 may be configured to receive the first capacitor 301, the second pocket 312 may be configured to receive the second capacitor 302, the third pocket 313 may be configured to receive the third capacitor 303, the fourth pocket 314 may be configured to receive the fourth capacitor 304, and the fifth pocket 315 may be configured to receive the fifth capacitor 305.

The first pocket 311 may be defined by surfaces of the first wall 321, the second wall 322, the first sidewall 327, and the second sidewall 328. Each of these respective walls may include a surface configured to transfer heat from the first capacitor 301. A distance between a surface of the first wall 321 and a surface of the second wall 322 may increase in a direction away from the floor 340. The first pocket 311 may be configured to receive one or more capacitors (e.g., one or more of first capacitor 301 or second capacitor 302). Second pocket 312, third pocket 313, fourth pocket 314, and fifth pocket 315 may similarly be defined by walls and surfaces of heat sink 350, and may similarly be configured to receive one or more capacitors (e.g., of capacitor assembly 310.)

The second wall 322, the third wall 323, the fourth wall 324, and the fifth wall 325 may each include a first surface and a second surface on opposite sides of the respective wall. Each respective surface may define a portion of a different pocket. For example, second wall 322 may include a first surface configured to transfer heat from a surface of the first capacitor 301 and a second surface configured to transfer heat from a surface of the second capacitor 302. The first surface may define a portion of the first pocket 311 and the second surface may define a portion of the second pocket 312. The first wall 321 and sixth wall 326 may have a height from floor 340 that is greater than that of the second wall 322, the third wall 323, the fourth wall 324, and the fifth wall 325. Shorter walls between adjacent capacitors may provide additional space for epoxy overflow between capacitors and walls. Higher external walls of the heat sink 350 (e.g., first wall 321 and sixth wall 326, and first sidewall 327 and second sidewall 328) may provide additional heat transfer capability in areas where epoxy overflow is less of an issue.

The chassis 320 may include an inlet 331 and an outlet 332. Both the inlet 331 and the outlet 332 may be a conduit for coolant, where, based on the direction of the flow of coolant, the inlet 331 may be configured as an outlet and the outlet 332 may be configured as an inlet. The inlet 331 and outlet 332 may, for example, be tubular in shape and may include an opening through which coolant may flow. The opening may be circular or any polygonal shape. The inlet 331 may be configured to transfer coolant into one or more components of inverter assembly 300 and may contact exterior surfaces of heat sink 350. The outlet 332 may be configured to transfer coolant from the heat sink 350. The inlet 331 and outlet 332 may both be positioned on a same side of the second sidewall 328.

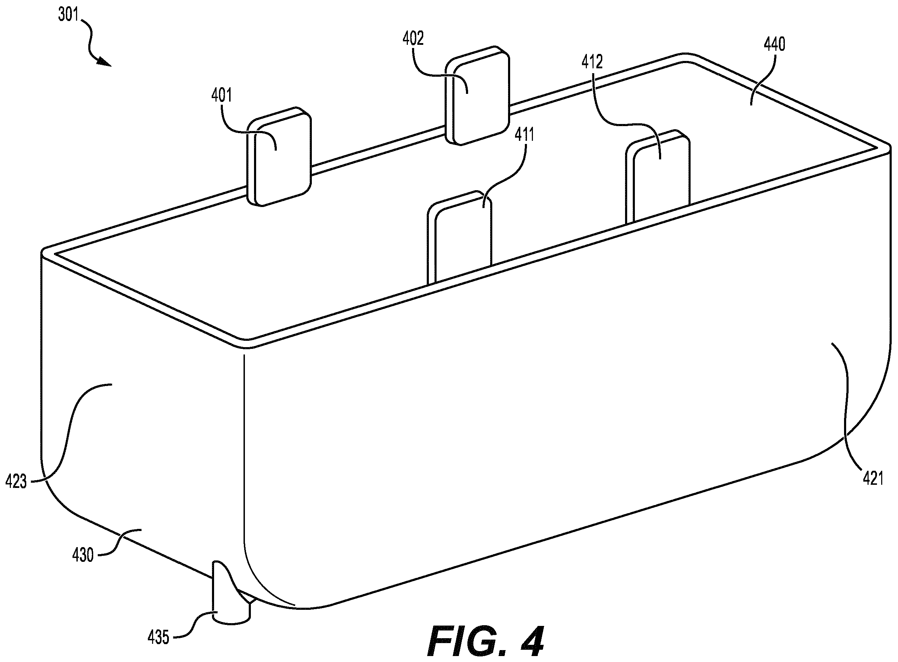

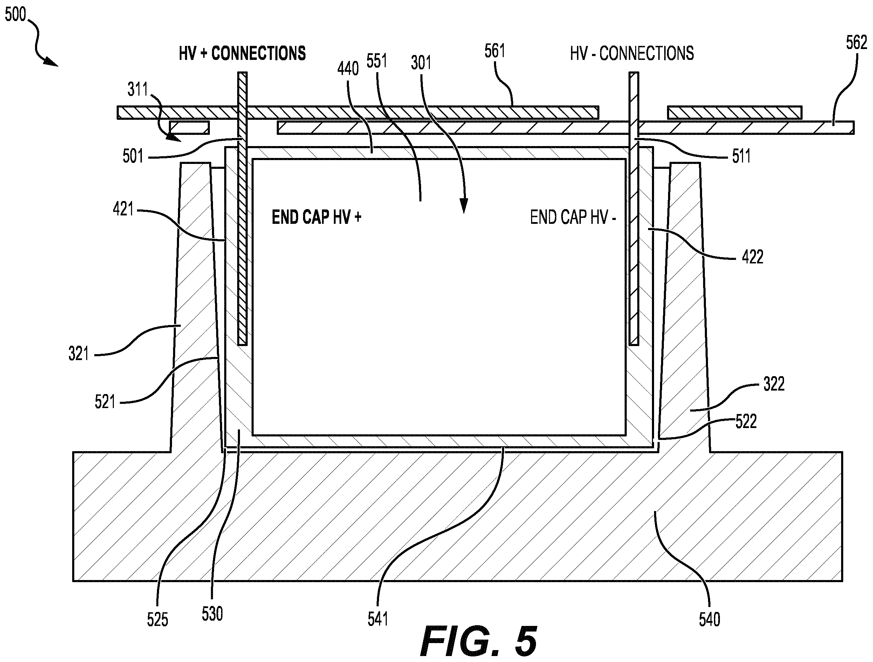

FIG. 4 depicts an exemplary capacitor element (e.g., the first capacitor 301), according to one or more embodiments. The first capacitor 301 may include a first capacitor side wall 421 opposite to a second capacitor side wall 422 (as depicted in FIG. 5). The first capacitor may include a third capacitor side wall 423, which connects first capacitor side wall 421 to second capacitor side wall 422. The third capacitor side wall 423 may include a curved portion 430. The first capacitor 301 may include a top wall 440. The top wall 440 may extend across a surface of the first capacitor 301 and connect to the first capacitor side wall 421, the second capacitor side wall 422, and the third capacitor side wall 423.

The first capacitor 301 may include a first HV+ connection 401 and a second HV + connection 402 that each extend from the top wall 440 of the first capacitor 301. The first HV+ connection 401 and second HV + connection 402 may be copper tabs. The first HV+ connection 401 and second HV + connection 402 may be connected as a part of a singular plate within the first capacitor 301. The first capacitor 301 may include a first HV- connection 411 and a second HV - connection 412 that each extend from the top wall 440 of the first capacitor 301. The first HV-connection 411 and a second HV - connection 412 may be copper tabs. The first HV- connection 411 and a second HV - connection 412 may be connected as a part of a singular plate within the first capacitor 301.

The first capacitor 301 may include a locator 435 (e.g., one or more locators, e.g., four locators). The locator 435 may include a protrusion configured to align the first capacitor 301 within a particular pocket (e.g., the first pocket 311 of FIG. 3) of the heat sink 350. For example, the heat sink 350 may include a matching cavity that is configured to receive the locator 435. The locator 435 may be located on the curved portion 430 of the third capacitor side wall 423.

FIG. 5 depicts a cross section of an exemplary inverter package 500, according to one or more embodiments. The cross section of the exemplary inverter package 500 may display a cross section of the chassis 320 and capacitor assembly 310 of FIG. 3 when the chassis 320 and the capacitor assembly 310 are assembled.

The inverter package 500 may include a floor 540 of chassis 320, and a first wall 321 and a second wall 322 that extend from the floor 540 of the chassis 320. The first wall 321 and second wall 322 may be configured to receive the first capacitor 301. The first wall 321 may include a first surface 521 configured to transfer heat from the first capacitor side wall 421. The second wall 322 may include a second surface 522 configured to transfer heat from the second capacitor side wall 422. The floor 540 may be configured to receive heat from a bottom surface 541 of the first capacitor 301. The floor 540 may be shaped to receive the bottom surface 541 of the first capacitor 301. For example, although not depicted, a portion of the floor 540 may be curved to receive the curved portion 430 of the sidewalls as shown in FIG. 4. The floor 540, although not depicted, may include one or more recesses configured to receive a locator 435 (e.g., one locator, e.g., two locators, e.g., four locators) of the first capacitor 301. The recess may provide a structure to seat the first capacitor 301 correctly within the first pocket 311.

The inverter package 500 may include a gap filled with a thermally conductive gap filler 525 located between the first capacitor 301 and the first wall 321, second wall 322, and floor 540. The first capacitor 301 may include an insulation element 530 that surrounds an inner capacitive element 551. The inner capacitive element 551 may be wound metalized polypropylene film. The first capacitor 301 may include a first connection plate 501 and a second connection plate 511 located at opposite sides of the first capacitor 301. The first connection plate 501 may be configured to transfer heat from an end cap for HV+ and the second connection plate 511 may be configured to transfer heat from an end cap for HV-. The respective end caps may be arc sprayed zinc applied to the metalized polypropylene film at respective ends of the inner capacitive element 551. The first connection plate 501 may include a tab that extends out of the first capacitor 301 and provides an HV+ connection to a first DC busbar 561. The second connection plate 511 may include a tab that extends out of the first capacitor 301 and provides an HV- connection to a second DC busbar 562. The first connection plate 501 and second connection plate 511 may include copper and may allow for efficient heat transfer (e.g., with the first wall 321 and second wall 322) and electrical connections with the respective busbars (e.g., the first DC busbar 561 and second DC busbar 562). The first connection plate 501 and second connection plate 511 may transfer a highest amount of heat from the first capacitor 301, and by being aligned with walls of the chassis 320, may efficiently transfer heat to the walls, which may cool the first capacitor 301 more efficiently.

In one or more embodiments described herein, a problem of thermal overload of capacitive elements without cooling of electrode plate(s) may be addressed by using extended wall sections to create pockets in aluminum chassis walls to provide a path for heat transfer from end caps of capacitive elements of the aluminum chassis.

One or more embodiments may include an integration and placement of bulk capacitor components within a main inverter enclosure (e.g., a chassis). The main inverter enclosure may be generally made from highly conductive aluminum and may be constructed in such a way to surround each capacitor bobbin and/or element for enabling internal heat sinking.

One or more embodiments may include extended wall sections, which may provide pockets in aluminum chassis walls to increase available surface areas to end caps of capacitive elements. In one or more embodiments, a thermal conductivity of the capacitive elements may be approximately six times (e.g., 6x) better in a direction between the end caps of the capacitive elements than across the body of the capacitive elements.

In one or more embodiments, additional surface area of casting walls next to optimum surfaces of the capacitive elements for cooling may help compensate for the relatively poor thermal conductivity of high voltage insulation and epoxy. In one or more embodiments, an interface may be provided with a more efficient (or improved) path for heat transfer from the end caps of the capacitive elements than cooling from the exterior through multiple insulating materials.

In one or more embodiments, by increasing the thermal efficiency of the bulk capacitor, less capacitance may be used in cases where thermal limitations are driving the amount of capacitance compared to electrical filtering. In one or more embodiments, the extended wall pockets in the aluminum chassis casting may provide additional surface area and a more efficient path for heat transfer through the HV+/HV- end caps of the capacitive elements. In one or more embodiments, using aluminum material as a heatsink may be beneficial for being less expensive than extra copper bus bars and the extended wall pockets may add stiffness to the aluminum chassis casting.

Other embodiments of the disclosure will be apparent to those skilled in the art from consideration of the specification and practice of the invention disclosed herein. It is intended that the specification and examples be considered as exemplary only, with a true scope and spirit of the invention being indicated by the following claims.

## Claims

1. A system comprising a heat sink for a capacitor assembly for an inverter, the heat sink including:
a first pocket extending from a chassis of the inverter, wherein the first pocket includes a first surface configured to transfer heat from a first surface of a first capacitor and a second surface configured to transfer heat from a second surface of the first capacitor; and
a second pocket extending from the chassis of the inverter, wherein the second pocket includes a first surface configured to transfer heat from a first surface of a second capacitor and a second surface configured to transfer heat from a second surface of the second capacitor.

2. The system of claim 1, wherein the second surface of the first pocket is on an opposite side of a wall from the first surface of the second pocket;
and/or, wherein the first surface of the first pocket is opposite to the second surface of the first pocket.

3. The system of any one of claims 1 to 2, wherein the first pocket further includes:
a third surface connecting the first surface of the first pocket to the second surface of the first pocket, the third surface being configured to transfer heat from a third surface of the first capacitor;
and preferably, a fourth surface connecting the first surface of the first pocket to the second surface of the first pocket, the fourth surface opposite to the third surface of the first pocket and being configured to transfer heat from a fourth surface of the first capacitor.

4. The system of any one of claims 1 to 3, wherein the heat sink further includes:
thermally conductive gap filler between the first surface and first capacitor.

5. The system of any one of claims 1 to 4, wherein the heat sink is cast aluminum.

6. The system of any one of claims 1 to 5, wherein the heat sink is configured to receive coolant through an inlet and an outlet of the chassis.

7. The system of any one of claims 1 to 6, wherein the heat sink further includes:
a floor extending across the first pocket and the second pocket, and integrated with the chassis of the inverter;
and preferably, wherein the first pocket further includes a recess to receive a protrusion of the first capacitor to position the first capacitor in the first pocket.

8. The system of any one of claims 1 to 7, further comprising:
the inverter including the heat sink, the inverter configured to convert DC power from a battery to AC power to drive a motor,
the battery configured to supply the DC power to the inverter; and
the motor configured to receive the AC power from the inverter to drive the motor,
wherein the inverter, the battery, and the motor are provided as a vehicle.

9. A system comprising an inverter to convert direct current (DC) power from a battery to alternating current (AC) power to drive a motor, wherein the inverter includes:
a chassis including a floor and a heat sink for a capacitor assembly, the heat sink including:
a first pocket extending from the floor of the chassis, wherein the first pocket includes a first surface configured to transfer heat from a first surface of a first capacitor and a second surface configured to transfer heat from a second surface of the first capacitor; and
a second pocket extending from the floor of the chassis, wherein the second pocket includes a first surface configured to transfer heat from a first surface of a second capacitor and a second surface configured to transfer heat from a second surface of the second capacitor.

10. The system of claim 9, wherein the heat sink is configured to transfer heat from the first capacitor and the second capacitor to the floor of the chassis.

11. The system of any one of claims 9 to 10, wherein the chassis further includes an inlet for coolant and an outlet for the coolant.

12. The system of claims 9 to 11, wherein the first surface of the first capacitor and the second surface of the first capacitor are end caps of the first capacitor;
and/or, wherein one or more of the first pocket or the floor includes a recess to receive a protrusion of the first capacitor to position the first capacitor in the first pocket.

13. A system comprising a heat sink, the heat sink including:
a first pocket of a chassis, wherein the first pocket includes a first surface configured to receive heat from a first connection plate of a first capacitive element and a second surface configured to receive heat from a second connection plate of the first capacitive element; and
a second pocket of the chassis, wherein the second pocket includes a first surface configured to receive heat from a first connection plate of a second capacitive element and a second surface configured to receive heat from a second connection plate of the second capacitive element.

14. The system of claim 13, wherein the heat sink and the chassis are cast aluminum.

15. The system of any one of claims 13 to 14, wherein the chassis further includes an inlet for coolant and an outlet for the coolant:
and/or, wherein the heat sink further includes a sidewall providing a third surface for the first pocket and the second pocket.
